# EUROPÄISCHE PATENTSCHRIFT

(11) **EP 3 224 917 B1**
(45) Veröffentlichungstag und Bekanntmachung des Hinweises auf die Patenterteilung: **12.02.2020**
(21) Anmeldenummer: 15797665.5
(22) Anmeldetag: 19.11.2015
(51) Int. Cl.: H01S 5/02, H01S 5/22, H01L 33/00, H01L 33/20

(54) **OPTOELEKTRONISCHES BAUELEMENT UND VERFAHREN ZUR HERSTELLUNG EINES OPTOELEKTRONISCHEN BAUELEMENTES**
OPTOELECTRONIC COMPONENT AND METHOD FOR PRODUCING AN OPTOELECTRONIC COMPONENT
COMPOSANT OPTOÉLECTRONIQUE ET PROCÉDÉ DE PRODUCTION D'UN COMPOSANT OPTOÉLECTRONIQUE

(30) Priorität: 28.11.2014 DE 102014117510
(43) Veröffentlichungstag der Anmeldung: 04.10.2017
(73) Patentinhaber: OSRAM Opto Semiconductors GmbH, 93055 Regensburg (DE)
(72) Erfinder: GERHARD, Sven, 93107 Thalmassing (DE); LELL, Alfred, 93142 Maxhütte-Haidhof (DE)
(74) Vertreter: Patentanwaltskanzlei WILHELM & BECK
(86) Internationale Anmeldenummer: PCT/EP2015/077142
(87) Internationale Veröffentlichungsnummer: WO 2016/083246

(56) Entgegenhaltungen:
- JP-A- 2010 123 869
- JP-B2- 4 266 694
- US-A1- 2005 151 153
- US-A1- 2008 298 409
- US-A1- 2010 265 981
- US-A1- 2013 001 588
- US-B2- 7 724 793

## Beschreibung

Die Erfindung betrifft ein optoelektronisches Bauelement gemäß Patentanspruch 1 und ein Verfahren zur Herstellung eines optoelektronischen Bauelementes gemäß Patentanspruch 11.

Diese Patentanmeldung beansprucht die Priorität der deutschen Patentanmeldung 10 2014 117 510. 7.

Aus US 7724793 ist ein optoelektronisches Bauelement bekannt, das eine Ausnehmung aufweist, wobei die Ausnehmung an eine Spiegelfläche angrenzt. Die Ausnehmung weist senkrechte Seitenwände und eine Bodenfläche auf.

Aus US 2013/0001588 A1 ist ein optoelektronisches Bauelement mit einer Schichtstruktur mit einer aktiven Zone zum Erzeugen einer elektromagnetischen Strahlung bekannt, wobei in eine Oberseite der Schichtstruktur eine Ausnehmung mit senkrecht zur Ebene der aktiven Zone ausgerichteten Seitenflächen eingebracht ist. Die Ausnehmung ist seitlich beabstandet zur aktiven Zone angeordnet.

Auch die Dokumente JP 4266694 B2, US 2005/0151153 A1 und US 2010/265981 A1 zeigen entsprechende Bauelemente.

Die Aufgabe der Erfindung besteht darin, ein verbessertes Bauelement und ein verbessertes Verfahren zum Herstellen eines Bauelementes bereitzustellen.

Die Aufgabe der Erfindung wird durch das Bauelement gemäß Patentanspruch 1 und durch das Verfahren gemäß Patentanspruch 14 gelöst. Ein Vorteil des vorgeschlagenen Bauelementes besteht darin, dass die Ausnehmung wenigstens eine geneigte Seitenfläche aufweist. Die Ausnehmung mit der geneigten Seitenfläche weist den Vorteil auf, dass die geneigte Seitenfläche zuverlässig mit einem Dielektrikum überformt werden kann, um eine Passivierung der Oberfläche zu erreichen. Zudem ist es nicht notwendig, bei einer Ausnehmung mit einer geneigten Seitenfläche bei der Herstellung die Tiefe der Ausnehmung präzise zu kontrollieren. Für eine effektive Wirkung der Ausnehmung zum Unterbinden von Versetzungen an einer Bruchkante ist die Ausbildung der Ausnehmung mit einer festgelegten Tiefe im Bereich der aktiven Zone von Vorteil. Dabei ist die Bodenfläche der Ausnehmung im Bereich der aktiven Zone angeordnet. Die Bodenfläche kann in einem Bereich oberhalb oder unterhalb der aktiven Zone angeordnet sein. Insbesondere ist die Bodenfläche der Ausnehmung in einem Bereich von 200 nm über der Ebene der aktiven Zone bis zu 200 nm unter der Eben der aktiven Zone angeordnet. Das optoelektronische Bauelement kann z.B. als Laserdiode oder als Licht emittierende Diode ausgebildet sein.

Versuche haben gezeigt, dass eine Tiefe der Ausnehmung im Bereich zwischen 100 nm und 800 nm von Vorteil ist. Sind die Ausnehmungen zu flach, sind sie für eine Reduzierung von Versetzungen, insbesondere an einer Spiegelfläche nahezu wirkungslos. Bei einer Ausbildung mit einer Ausnehmung, die zu tief ist, kann die Ausnehmung selbst wieder wie ein Störzentrum wirken, an dem sich Versetzungen bilden können.

Diese Offenlegung weist mehrere Ausführungsformen auf, von denen einige Ausführungsformen der beanspruchten Erfindung sind.

In einer Ausführungsform weist die Ausnehmung eine Tiefe in Bezug auf die Oberfläche der Schichtstruktur auf, die im Bereich zwischen 100 nm und 800 nm liegt. Auf diese Weise wird ein ausreichender Schutz der aktiven Zone erreicht.

In einer weiteren Ausführungsform weist wenigstens eine Seitenfläche, insbesondere beiden Seitenflächen einen Winkel von 95° bis 160° geneigt gegenüber der Ebene der aktiven Zone auf. Durch diese Winkelbereiche wird ein guter Schutz der aktiven Zone gegen die Ausbildung von Versetzungen an einer Bruchfläche ermöglicht. Abhängig von der gewählten Ausführung können die Seitenflächen spiegelsymmetrisch zueinander angeordnet sein oder in unterschiedlichen Neigungswinkeln geneigt angeordnet sein.

Insbesondere durch eine geneigte Seitenfläche, die dem aktiven Bereich der aktiven Zone zugewandt ist, kann erreicht werden, dass Versetzungen, die ausgehend von der Ausnehmung in Richtung auf den aktiven Bereich der aktiven Zone sich ausbilden, nach unten abgelenkt werden und unter der aktiven Zone verlaufen. Dieser Effekt wird dadurch bewirkt, dass Versetzungen sich immer senkrecht zu einer Seitenfläche ausbilden.

Abhängig von der gewählten Ausführungsform kann die Ausnehmung in einem seitlichen Randbereich des Bauelementes angeordnet sein und beispielsweise nur eine Seitenfläche in der Bruchrichtung aufweisen, die der aktiven Zone zugewandt ist. In einer weiteren Ausführungsform weist die Ausnehmung zwei Seitenflächen auf, wobei wenigstens eine der zwei Seitenflächen, insbesondere die Seitenfläche, die der aktiven Zone zugewandt ist, geneigt gegenüber der ersten Ebene der aktiven Zone angeordnet ist.

In einer weiteren Ausführungsform weist die Seitenfläche zwei Flächenabschnitte auf, wobei ein Flächenabschnitt geneigt angeordnet ist und der zweite Flächenabschnitt im Wesentlichen senkrecht zur Ebene der aktiven Zone ausgerichtet ist. Abhängig von der gewählten Ausführungsform kann der geneigte Flächenabschnitt oberhalb des geraden Flächenabschnittes oder unterhalb des geraden Flächenabschnittes angeordnet sein.

In einer weiteren Ausführungsform weist die Ausnehmung in einer Ebene parallel zur zweiten Ebene wenigstens einen gerundeten Übergang zwischen der Seitenfläche der Ausnehmung und einer Oberseite der Schichtstruktur und/oder einer Bodenfläche der Ausnehmung auf. Durch die gerundete Ausbildung der Kanten im Übergangsbereich der Flächen kann die Ausbildung von Störungen insbesondere von Versetzungen reduziert werden. Insbesondere scharfkantige Übergänge zwischen Flächen können Ausgangspunkte für weitere Störungen sein.

In einer weiteren Ausführungsform, die eine Ausführungsform der beanspruchten Erfindung ist, weist die Seitenfläche zwei übereinander angeordnete Seitenabschnitte auf, wobei die Seitenabschnitte seitlich zueinander versetzt angeordnet sind. Die Seitenabschnitte sind über eine zweite Bodenfläche miteinander verbunden. Abhängig von der gewählten Ausführungsform können beide Seitenabschnitte oder nur einer der zwei Seitenabschnitte geneigt und der andere Seitenabschnitt senkrecht ausgerichtet sein.

Versuche haben gezeigt, dass mit einer Ausnehmung, die eine Ausdehnung in der zweiten Ebene senkrecht zur Längserstreckung des aktiven Bereichs der aktiven Zone im Bereich von 10 µm bis 200 µm gute Effekte für die Unterdrückung von Störungen, insbesondere von Versetzungen im Bereich der Endfläche, das heißt im Bereich der Facette der Laserdiode oder der Licht emittierenden Diode (LED) erreicht werden.

Zudem haben Versuche gezeigt, dass gute Ergebnisse bei der Unterdrückung von Facettenstörungen erreicht werden, wenn die Ausnehmung einen Abstand im Bereich von 10 µm bis 150 µm von dem aktiven Bereich der aktiven Zone aufweist. In einer weiteren Ausführungsform ist ein Mesagraben zwischen einer Seite des Bauelementes und der Ausnehmung vorgesehen. Durch den Mesagraben können Verspannungen der Schichtstruktur reduziert werden.

In einer Ausführung wird ein Verfahren zur Herstellung eines Bauelementes verwendet, wobei die Ausnehmung mithilfe eines Ätzprozesses in die Schichtstruktur eingebracht wird, wobei während des Ätzprozesses eine laterale Aufweitung einer Ätzöffnung einer Ätzmaske wenigstens teilweise erfolgt, so dass die Ausnehmung wenigstens eine geneigt angeordnete Seitenfläche aufweist.

In einer weiteren Ausführung werden unterschiedlich harte Ätzmasken während des Ätzprozesses verwendet, um die Ausnehmung mit wenigstens einer geneigten Seitenfläche zu erzeugen. Eine weiche Ätzmaske kann beispielsweise aus Photolack, oder SiNx oder ein Halbleitermaterial oder ein Metall ausgebildet sein.

Die Erfindung wird im Folgenden anhand der Figuren näher erläutert. Es zeigen:
- Figur 1: einen schematischen Blick auf eine Endfläche eines optoelektronischen Bauelements,
- Figur 2: eine vergrößerte Darstellung eines Ausschnittes der Figur 1,
- Figur 3: eine schematische Darstellung einer weiteren Ausführungsform einer Ausnehmung,
- Figur 4: eine schematische Darstellung einer weiteren Ausführungsform einer Ausnehmung, wobei obere Seitenflächen senkrecht und untere Seitenflächen geneigt ausgebildet sind,
- Figur 5: eine weitere Ausführungsform einer Ausnehmung, wobei obere Seitenflächen geneigt und untere Seitenflächen senkrecht ausgebildet sind,
- Figur 6: eine weitere Ausführungsform einer Ausnehmung, wobei die zwei Seitenflächen unterschiedliche Winkel zur Ebene der aktiven Zone einnehmen,
- Figur 7: eine weitere Ausführungsform, wobei zwei Ausnehmungen auf gegenüberliegenden Seiten eines Steges der Laserdiode angeordnet sind,
- Figur 8: eine Draufsicht auf eine Endfläche einer Laserdiode mit einer weiteren Ausführungsform einer Ausnehmung und schematisch dargestellten Versetzungen,
- Figur 9: eine Draufsicht auf eine Endfläche eines optoelektronischen Bauelementes mit einer Ausnehmung und mit einem Mesagraben,
- Figur 10: eine weitere Ausführungsform, die eine Ausführungsform der beanspruchten Erfindung ist, bei der ein Mesagraben in eine Ausnehmung übergeht,
- Figur 11: eine Ansicht von oben auf ein Bauelement,
- Figuren 12 bis 14: Verfahrensschritte eines ersten Verfahrens zur Herstellung der Ausnehmung,
- Figuren 15 bis 18: Verfahrensschritte eines zweiten Verfahrens zur Herstellung einer Ausnehmung, und
- Figuren 19 und 20: Verfahrensschritte eines dritten Verfahrens.

Eine Idee der vorliegenden Ausführungsbeispiele besteht darin, mithilfe von wenigstens einer Ausnehmung mit wenigstens einer Seitenfläche, die einem Modenraum, d.h. einem aktiven Bereich der aktiven Zone der Laserdiode oder der Licht emittierenden Diode (LED) zugewandt ist, und die in einem Winkel ungleich 90° gegenüber der Ebene der aktiven Zone der Laserdiode oder der Licht emittierenden Diode (LED) angeordnet ist, die Ausbildung von stufenförmigen Störungen an einer Spaltkante, das heißt eine durch eine Spaltung hergestellten Endfläche der Laserdiode/LED zu reduzieren oder zu vermeiden. Zudem sind die Ausnehmungen in der Weise ausgebildet, dass eine effiziente Abschirmung der aktiven Zone gegen Versetzungen im Modenraum erreicht wird. Zudem sind die Geometrie und die Anordnung der Ausnehmung in der Weise gewählt, dass die Ausnehmung schnell hergestellt werden kann.

Versuche haben gezeigt, dass flach auslaufende und insbesondere verrundete Flanken einer Ausnehmung dazu führen, dass eine Ätztiefe deutlich unkritischer ist und auch tiefer geätzte Ausnehmungen mit flach auslaufenden und/oder verrundeten Flanken nicht selbst als Störzentren für die Ausbildung von stufenförmigen Versetzungen der Spaltkante beim Spalten der Spaltkante wirken, wobei die stufenförmigen Versetzungen wieder in den aktiven Bereich der Laserdiode/LED laufen können. Ein Grund hierfür liegt darin, dass flach abfallende oder verrundete Flanken im Vergleich zu senkrechten Flanken eine deutliche Verringerung von Verspannungsfeldern aufweisen. Derart ausgebildete Ausnehmungen müssen somit nicht so genau in ihrer Ätztiefe kontrolliert werden wie Ausnehmungen mit senkrechten Flanken. Dadurch wird eine deutliche Prozessvereinfachung erreicht.

Weiterhin werden Ausnehmungen mit flach auslaufenden Flanken besser von einer dielektrischen Passivierung überformt, sodass eine Verbesserung der Qualität und eine Erhöhung der Ausbeute der Bauelemente erreicht wird. Auch haben Versuche gezeigt, dass schräge Flanken der Ausnehmung im Bereich einer Querfacette die Querfacette zum Abbiegen in Richtung Waferoberfläche bringen, sodass ein effektiveres Abfangen einer Querfacette erreicht wird. Somit kann ein optoelektronisches Bauelement mit einer guten Oberflächenqualität im aktiven Bereich der Laserfacette bereitgestellt werden. Dadurch können geringe Schwellströme, hohe Steilheiten, eine hohe Effizienz sowie eine hohe Bauelementstabilität und eine gute Strahlqualität erreicht werden.

Das optoelektronisches Bauelement ist beispielsweise als kantenemittierende Laserdiode oder als Licht emittierende Diode (LED) ausgebildet. Insbesondere kann die Laserdiode/LED aus einem III-V-Halbleitermaterial, insbesondere aus Indiumgalliumnitrid, hergestellt werden.

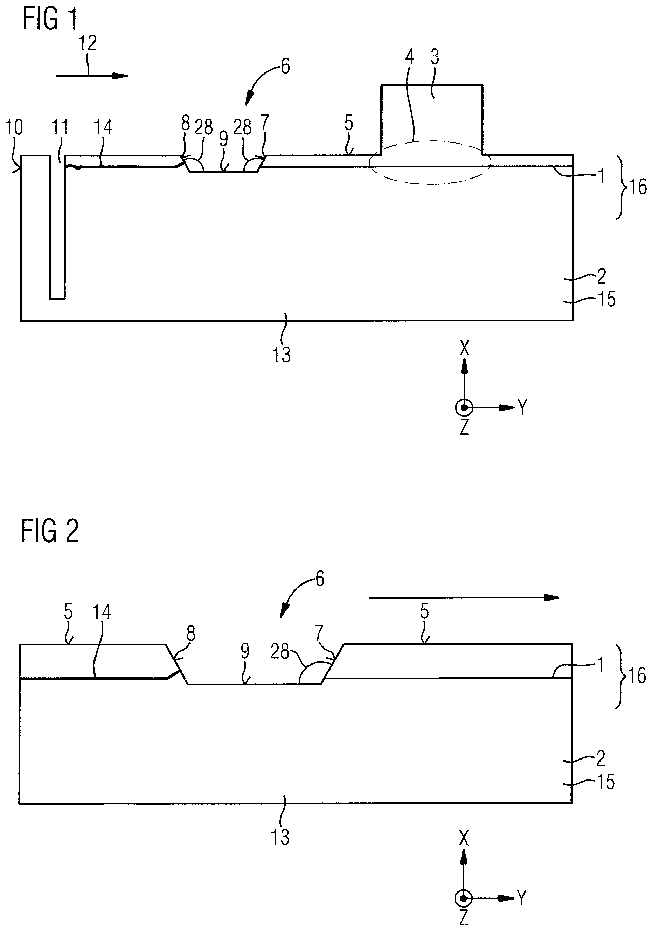

Figur 1 zeigt in einer schematischen Darstellung einen Blick auf eine Endfläche 13 eines optoelektronischen Bauelements, das z. B. als Licht emittierende Diode (LED) oder als Laserdiode, insbesondere als Streifenlaserdiode ausgebildet ist. Es ist eine Schichtanordnung vorgesehen, die im oberen Endbereich eine Schichtstruktur 2 mit einer aktiven Zone 1 aufweist. Die aktive Zone 1 kann mehrere Schichten aufweisen, die in einer ersten Ebene angeordnet sind. Die erste Ebene ist senkrecht zur Bildebene ausgerichtet. Die erste Ebene ist parallel zur y-Achse und zur z- Achse ausgebildet. Die x-Achse ist senkrecht zur y-Achse ausgerichtet. Die z-Achse steht senkrecht auf der Ebene y-x. Auf der Schichtstruktur 2 ist ein Steg 3 angeordnet, der entlang der z-Achse ausgerichtet ist. Der Steg 3 dient zur Konzentration des Laserlichtes unterhalb des Steges 3 in einem Lasermodenbereich 4. Der Lasermodenbereich 4 erstreckt sich entlang der z-Achse und nimmt einen Bereich der aktiven Zone 1 und angrenzender Schichten unter dem Steg 3 ein. Seitlich neben dem Steg 3 ist in die Oberfläche 5 der Schichtstruktur 2 eine Ausnehmung 6 eingebracht. Die Ausnehmung 6 weist zwei Seitenflächen 7, 8 und eine Bodenfläche 9 auf. Die Seitenflächen 7, 8 sind in einem Winkel 28 geneigt zur ersten Ebene der aktiven Zone 1 angeordnet, der ungleich 90° ist. Die erste und die zweite Seitenfläche 7, 8 weisen beispielsweise einen Winkel 28 zwischen 95° und 160°, insbesondere zwischen 98° und 130°, auf. Abhängig von der gewählten Ausführungsform können die erste und die zweite Seitenfläche 7, 8 auch einen Winkel zwischen 100° und 115° gegenüber der ersten Ebene aufweisen. Die erste Seitenfläche 7 ist dem Lasermodenbereich 4 zugewandt. Die zweite Seitenfläche 8 ist gegenüberliegend zur ersten Seitenfläche 7 angeordnet. Abhängig von der gewählten Ausführungsform kann auf die zweite Seitenfläche 8 verzichtet werden und die Ausnehmung 6 kann sich bis zu einem seitlichen Randbereich 10 oder einem Graben 11 erstrecken, der einen Mesagraben darstellen kann. Der Graben 11 weist in dem dargestellten Ausführungsbeispiel senkrechte Seitenflächen auf und ist tiefer ausgebildet als die Ausnehmung 6.

Wird nun die Schichtstruktur 2 entlang einer Bruchrichtung 12 gebrochen, so kann an der gebrochenen Endfläche 13 beispielsweise ausgehend von einer Seitenfläche des Grabens 11 sich eine Versetzung 14 ausbilden. Durch das Vorsehen der Ausnehmung 6 kann die Versetzung 14 nicht bis in den Bereich der Lasermode 4 gelangen, sondern wird von der Ausnehmung 6 abgefangen. Die Endfläche 13 stellt eine Emissionsfläche bzw. eine Spiegelfläche dar, an der die elektromagnetische Strahlung, insbesondere die Lasermode, gespiegelt bzw. ausgegeben wird. Somit sind Versetzungen oder Störungen einer planen Bruchfläche 13 insbesondere im Bereich der Lasermode 4 zu vermeiden. Für eine optimale Wirkung als Spiegelfläche oder Emissionsfläche sollte die Bruchfläche 13 im Bereich der Lasermode 4 möglichst versetzungsfrei sein.

Abhängig von der gewählten Ausführungsform kann auf den Graben 11, der einen Mesagraben darstellen kann, verzichtet werden. Die Schichtstruktur 2 kann im unteren Bereich ein Substrat 15 aufweisen, auf das epitaktisch gewachsene Schichten 16 abgeschieden wurden. Die Schichten 16 umfassen auch die aktive Zone 1. Das Substrat und/oder die Halbleiterschicht kann auf einem III-V-Verbindungshalbleiter oder einem II-VI-Verbindungshalbleiter oder Zinkoxid basieren. Der II-VI-Verbindungshalbleiter kann ein Sulfid oder ein Selenid sein. Der III-V-Verbindungshalbleiter kann auf einem Nitrid-Verbindungshalbleiter, einem Phosphid-Verbindungshalbleiter, einem Antimonit-Verbindungshalbleiter oder einem Arsenid-Verbindungshalbleiter basieren. Der III-V-Verbindungshalbleiter kann beispielsweise ein Nitrid wie etwa Galliumnitrid, Indiumnitrid oder Aluminiumnitrid, ein Phosphid wie etwa Galliumphosphid oder Indiumphosphid ein ersten Arsenid wie etwa Galliumarsenid oder Indiumarsenid sein. Dabei kann beispielsweise das Materialsystem AlₙIn₁₋ₙ₋ₘGaₘN vorgesehen sein, wobei 0 ≤ n ≤ 1, 0 ≤ m ≤ 1 und n+m ≤ 1 sein kann. Zudem kann das Materialsystem AlₙGaₘIn₁₋ₙ₋ₘP umfassen, wobei 0 ≤ n ≤ 1, 0 ≤ m ≤ 1 und n+m ≤ 1 ist. Zudem kann das Materialsystem AlₙGaₘIn₁₋ₙ₋ₘSb umfassen, wobei 0 ≤ n ≤ 1, 0 ≤ m ≤ 1 und n+m ≤ 1 ist.

Figur 2 zeigt in einer vergrößerten Darstellung die Ausnehmung 6 der Figur 1. Die Ausnehmung 6 weist beispielsweise eine Tiefe zwischen 100 nm und 800 nm, vorzugsweise zwischen 200 nm und 500 nm, insbesondere zwischen 300 nm und 450 nm auf. Mit der Tiefe ist der Abstand zwischen der Oberfläche 5 und der Bodenfläche 9 parallel zur x-Achse bezeichnet. Zudem kann die Ausnehmung 6 eine Länge entlang der y-Achse aufweisen, die im Bereich zwischen 10 µm und 200 µm, insbesondere im Bereich zwischen 20 µm und 100 µm, insbesondere zwischen 30 µm und 50 µm liegt. Mit der Länge ist der Abstand zwischen den oberen Endbereichen der Seitenflächen 7, 8, das heißt die Länge in der Ebene der Oberfläche 5 bezeichnet. Zudem weist die Ausnehmung 6 entlang der y-Achse gesehen einen Abstand zum Steg 3 auf, der im Bereich zwischen 10 µm und 150 µm, insbesondere zwischen 20 µm und 100 µm, insbesondere zwischen 30 µm und 50 µm liegt. Der Abstand wird dabei an der Oberfläche 5 gemessen und reicht vom oberen Rand der ersten Seitenfläche 7 bis zur Seitenfläche des Steges 3, die der Ausnehmung 6 zugewandt ist.

Durch die Anordnung auch der zweiten Seitenfläche 8 in Form einer geneigten Seitenfläche wird ein Abbiegen der Versetzung 14 nach oben im Bereich der zweiten Seitenfläche 8 erreicht. Dadurch werden Versetzungen 14 abgefangen. Die epitaktisch gewachsenen Schichten 16 im Bereich der aktiven Zone stellen verspannte Epischichten mit hohen Spannungsfeldern dar. Insbesondere beim Übergang zwischen einer Wellenleiterschicht und einer aktiven Zone entstehen hohe Spannungsfelder.

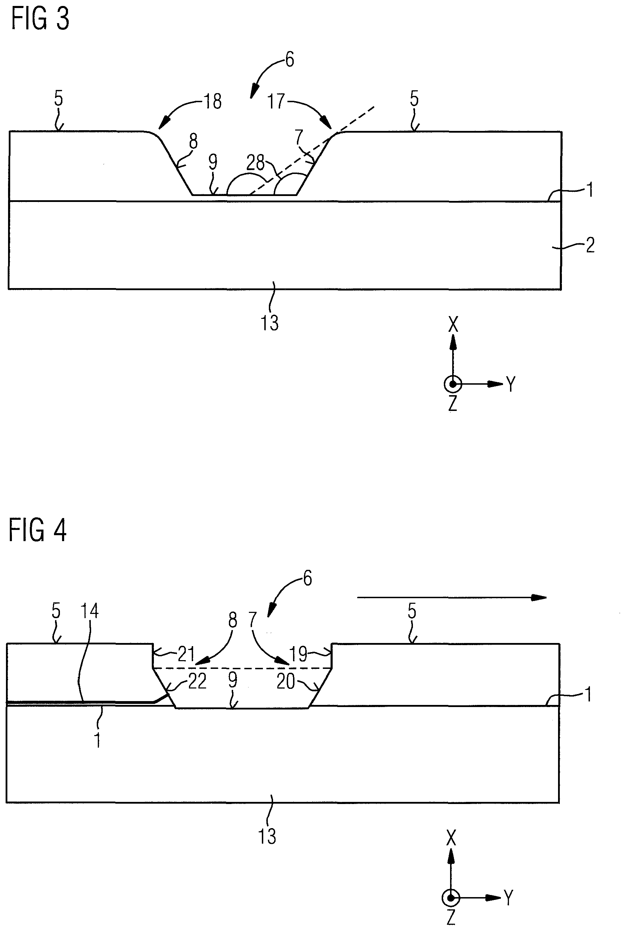

Figur 3 zeigt in einer schematischen Darstellung einen Ausschnitt eines weiteren optoelektronischen Bauelementes mit einer Ausnehmung 6, die im Wesentlichen wie die Ausnehmung der Figur 2 ausgebildet ist, wobei jedoch Übergangsbereiche 17, 18 zwischen der ersten Seitenfläche 7 und der zweiten Seitenfläche 8 und der entsprechenden angrenzenden Oberfläche 5 abgerundet ausgebildet sind. Durch die Ausbildung der abgerundeten Übergangsbereiche 17, 18 werden Spannungsfelder im Übergang zwischen der ersten und der zweiten Seitenfläche 7, 8 und der Oberfläche 5 reduziert.

Figur 4 zeigt eine weitere Ausführungsform einer Ausnehmung 6 eines optoelektronischen Bauelementes, wobei die Ausnehmung 6 Seitenflächen 7, 8 aufweist, die in zwei Seitenabschnitte 19, 20, 21, 22 unterteilt sind. Die oberen Seitenabschnitte 19, 21 der Seitenflächen 7, 8 sind im Wesentlichen senkrecht zur ersten Ebene, das heißt zur yz-Ebene, angeordnet. Die zweiten Seitenabschnitte 20, 22 der ersten und der zweiten Seitenfläche 7, 8 sind als geneigte Flächen ausgebildet. Der Neigungswinkel ist entsprechend dem Neigungswinkelbereich der Seitenflächen der Figuren 1 und 2 ausgebildet. Ebenso sind die Abstände und die Tiefen und die Längen der Ausnehmung 6 der Figur 4 gemäß den Bereichen der Ausführungsform der Figur 2 ausgebildet.

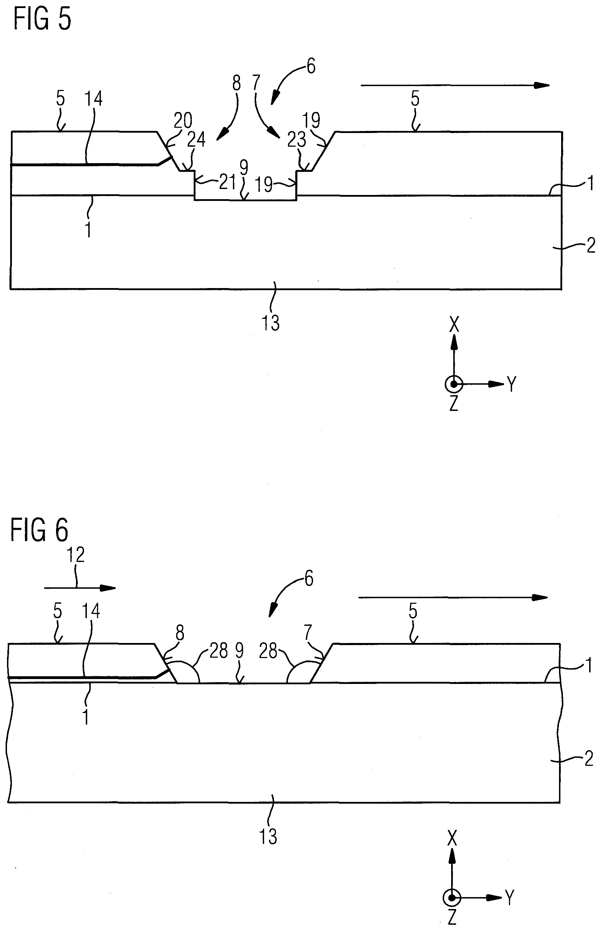

Figur 5 zeigt eine weitere Ausführungsform einer Ausnehmung, wobei in dieser Ausführungsform die oberen Seitenabschnitte 19, 21 als geneigte Seitenflächen ausgebildet sind. Die geneigten Seitenflächen sind in dem Winkelbereich der ersten und zweiten Seitenflächen 7, 8 der Ausführungsform der Figuren 1 und 2 angeordnet. Die unteren Seitenabschnitte 20, 22 der ersten und der zweiten Seitenfläche 7, 8 sind im Wesentlichen senkrecht zur ersten Ebene der aktiven Zone 1 d. h. der y-z-Ebene angeordnet. Weiterhin ist zwischen dem ersten Seitenabschnitt 19 und dem zweiten Seitenabschnitt 20 eine weitere erste Bodenfläche 23 angeordnet. Zudem ist zwischen dem weiteren ersten Seitenabschnitt 21 und dem weiteren zweiten Seitenabschnitt 22 eine weitere zweite Bodenfläche 24 angeordnet. Die Bodenflächen 23, 24 sind auf der gleichen Höhe angeordnet und weisen eine gleich große Fläche auf.

Figur 6 zeigt eine weitere Ausführungsform einer Ausnehmung 6 eines optoelektronischen Bauelementes gemäß Figur 1, wobei die zwei Seitenflächen 7, 8 unterschiedliche Neigungswinkel 28 gegenüber der ersten Ebene der aktiven Zone 1 aufweisen. Insbesondere ist der Neigungswinkel der ersten Seitenfläche 7, die dem Steg 3 zugewandt ist, kleiner als der Neigungswinkel der zweiten Seitenfläche 8. Die zweite Seitenfläche 8 ist der Seite zugewandt, von der aus die Endfläche 13 in der Bruchrichtung 12 gebrochen wird. Die Winkel der Neigung der Seitenflächen 7, 8 können gemäß den angegebenen Winkelbereichen zwischen 98° und 160°, insbesondere zwischen 98° und 130°, insbesondere zwischen 100° und 115° gegenüber der ersten Ebene der aktiven Zone 1 ausgerichtet werden. Abhängig von der gewählten Ausführung kann der Neigungswinkel der ersten Seitenfläche 7, die dem Steg 3 zugewandt ist, größer sein als der Neigungswinkel der zweiten Seitenfläche 8. Zudem können die Neigungswinkel der zwei Seitenflächen 7,8 auch identisch sein, d.h. die zwei Seitenflächen 7,8 können spiegelsymmetrisch zu einer gedachten Mittenebene angeordnet sein, die zwischen den zwei Seitenflächen angeordnet ist.

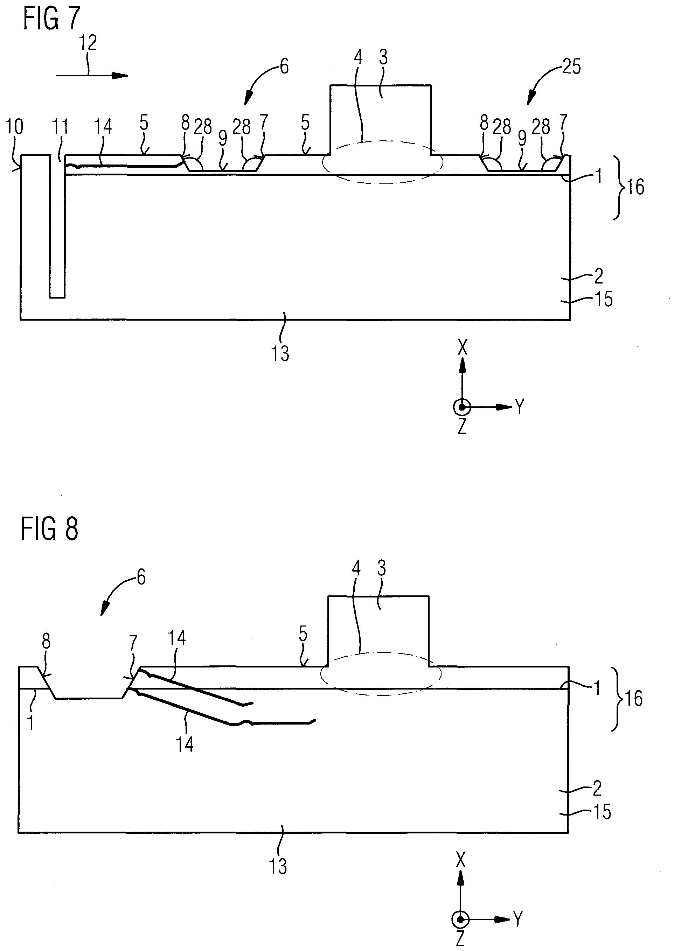

Figur 7 zeigt eine weitere Ausführungsform eines optoelektronischen Bauelementes, das im Wesentlichen gemäß Figur 1 ausgebildet ist, wobei jedoch auf beiden Seiten des Steges 3 eine Ausnehmung 6, 25 in die Oberfläche 5 der Schichtstruktur 2 eingebracht sind. Die zweite Ausnehmung 25 kann identisch zur Ausnehmung 6 ausgebildet sein. Insbesondere kann die zweite Ausnehmung 25 spiegelsymmetrisch zu der Ausnehmung 6 in Bezug auf den Steg 3 ausgebildet sein. Weiterhin können die Ausnehmungen 6, 25 unterschiedliche Formen und Tiefen aufweisen.

Figur 8 zeigt eine weitere Ausführungsform eines optoelektronischen Bauelementes, wobei die Ausnehmung 6 tiefer ausgebildet ist und die erste und/oder die zweite Seitenfläche 7, 8 in einem Winkel zwischen 98° und 130°, insbesondere in einem Winkel zwischen 100° und 115° geneigt zur ersten Ebene der aktiven Zone 1 angeordnet sind. In dieser Ausführungsform kann auch auf den Graben 11 verzichtet werden. Insbesondere durch eine geneigte Seitenfläche, die dem aktiven Bereich der aktiven Zone zugewandt ist, wird erreicht, dass Versetzungen 14, die ausgehend von der Ausnehmung 6 sich in Richtung auf den aktiven Bereich der aktiven Zone 1 ausbilden, nach unten abgelenkt werden und unter der aktiven Zone 1 verlaufen. Dieser Effekt wird dadurch bewirkt, dass Versetzungen 14 sich immer senkrecht zu einer Seitenfläche 7 ausbilden.

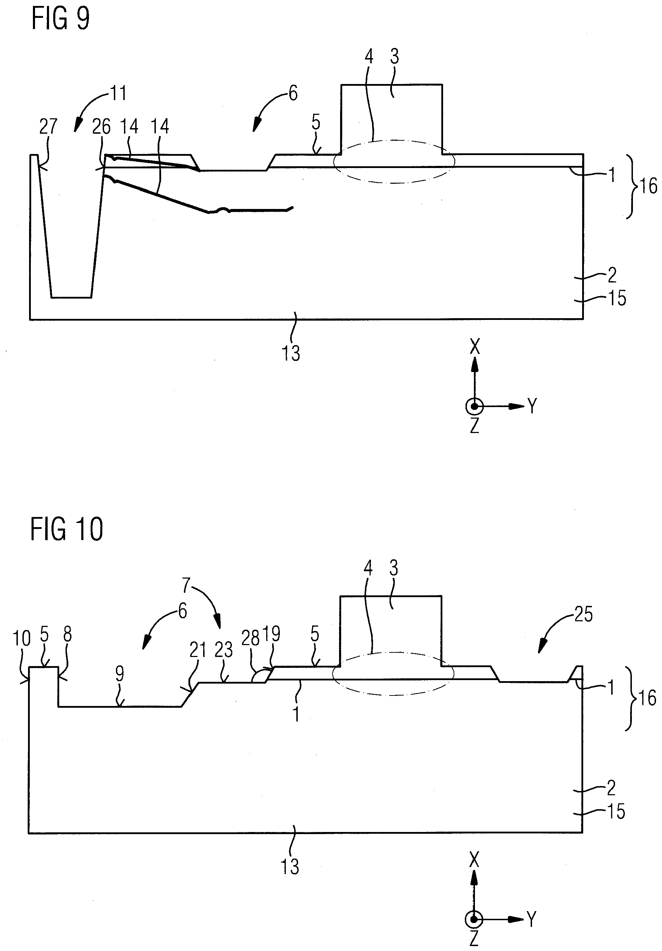

Figur 9 zeigt eine weitere Ausführungsform eines optoelektronischen Bauelementes, wobei der Graben 11 ebenfalls geneigte dritte und vierte Seitenflächen 27, 26 aufweist. Die Seitenflächen 27, 26 können eine Neigung gemäß den Seitenflächen 7, 8 aufweisen. Insbesondere durch die Ausbildung der geneigt angeordneten dritten Seitenfläche 26 werden sich an der dritten Seitenfläche 26 ausbildende Versetzungen 14 aufgrund der geneigten Anordnung der dritten Seitenfläche 26 unter den Bereich der Lasermode 4 geführt. Somit können diese Art von Versetzungen keine oder nur eine geringe Verschlechterung der Qualität der gebrochenen Endfläche 13 im Bereich der Lasermode 4, d.h. im aktiven Bereich der aktiven Zone 1 erzeugen.

Figur 10 zeigt eine weitere Ausführungsform eines optoelektronischen Bauelementes, die eine Ausführungsform der beanspruchten Erfindung ist, wobei die Ausnehmung 6 eine abgestufte erste Seitenfläche 7 und eine senkrecht angeordnete zweite Seitenfläche 8 aufweist. Die erste Seitenfläche 7 weist einen oberen ersten Seitenabschnitt 19, einen unteren zweiten Seitenabschnitt 20 und eine weitere erste Bodenfläche 23 auf.

Sowohl der obere als auch der untere Seitenabschnitt 19, 20 sind in einem Winkelbereich geneigt zur ersten Ebene der aktiven Zone 1 angeordnet. Der Winkel kann in einem Winkelbereiche zwischen 95° und 160°, insbesondere zwischen 98° und 130°, insbesondere zwischen 100° und 115°, liegen. Abhängig von der gewählten Ausführungsform können der erste und der zweite Seitenabschnitt 19, 20 den gleichen Winkel oder unterschiedliche Winkel aufweisen. Die weitere erste Bodenfläche 23 ist parallel zur ersten Ebene der aktiven Zone 1 angeordnet. Zudem kann abhängig von der gewählten Ausführungsform auch eine zweite Ausnehmung 25 vorgesehen sein. Die zweite Ausnehmung 25 kann gemäß der Ausnehmung 6 der Figur 2 ausgebildet sein.

Die weitere erste Bodenfläche 23 ist in der Tiefe angeordnet, in der die Bodenfläche 9 und die Ausnehmung 6 der Figur 2 angeordnet ist. Die weitere erste Bodenfläche 23 ist in einem Bereich zwischen 100 nm und 800 nm unterhalb der Oberfläche 5 angeordnet. Zudem ist die erste Bodenfläche 23 in einem Bereich zwischen 200 nm oberhalb und 200 nm unterhalb der Ebene der aktiven Zone angeordnet. Die Bodenfläche 9 ist in dieser Ausführungsform tiefer als die weitere erste Bodenfläche 23 der aktiven Zone 1 angeordnet und ersetzt somit die Funktion eines Mesagrabens, das heißt des tieferen Grabens 11 der Figur 1. Die Bodenfläche 9 ist beispielsweise tiefer als 200 nm unterhalb der Ebene der aktiven Zone 1 angeordnet.

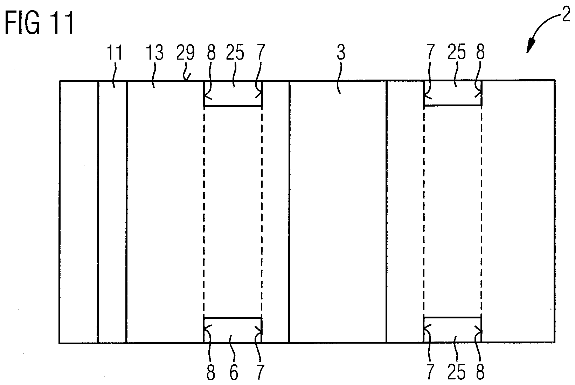

Figur 11 zeigt eine Laserdiode mit einem Steg 3, einem Mesagraben 11 und zwei gegenüber liegende Endflächen 13, 29. Zudem sind vier Ausnehmungen 6, 25 angrenzend an die Endflächen 13, 29 dargestellt. Abhängig von der gewählten Ausführung können die Ausnehmungen 6, 25 gemäß den vorab beschriebenen Beispielen ausgebildet sind. Zudem können die Ausnehmungen 6, 25 parallel zum Steg verlaufen, wie schematisch mit gestrichelten Linien dargestellt ist.

Halbleiterdioden erfordern für effiziente Strom- und Wellenführung eine Vielzahl epitaktischer Einzelschichten mit Schichtdicken im Bereich von wenigen Nanometern bis hin zu mehreren 100 nm. Jede dieser Schichten weist eine spezifische Materialzusammensetzung aus Galliumnitrid, und/oder Aluminiumgalliumnitrid, und/oder Indiumgalliumnitrid und/oder Aluminiumindiumgalliumnitrid auf. Die Schichten werden typischerweise mittels MOCVD bei Temperaturen zwischen 600 und 1200°C abgeschieden. Die Schichtstruktur 2 ist mehr oder weniger stark verspannt. Beim Spalten von Laserfacetten, das heißt von Endflächen 13 für kantenemittierende Laserdioden oder LEDs, treten deshalb entlang bestimmter Schichtebenen Stufen an der gespalteten Endfläche 13 auf. Störungen in der Facettenqualität können beispielsweise bei ELOG-artig hergestellten Substraten mit defektreichen Zonen oder an Skips ihren Ursprung haben.

Die Herstellung von Ausnehmungen 6 mit geneigten Seitenflächen 7, 8 und insbesondere mit verrundeten Übergangsbereichen 17, 18 kann hierbei durch eine Verwendung von Lackmasken anstelle von Hartmasken sowie mit einem speziell zur Ausbildung derartiger geneigter Seitenflächen optimierter Plasmaätzprozesse mit einer hohen Abtragerate erreicht werden. Auch die Verwendung von anderen Masken, die während des Ätzprozesses mittel bis stark abgetragen werden und so zu einem geneigten Winkel der Seitenflächen 7, 8 führen, stellen eine technologische Möglichkeit dar, die Ausnehmungen 6, 25 mit geneigten Seitenflächen zu erzeugen. Die Ausnehmungen 6, 25 können auf verschiedene Arten erzeugt werden. Durch die Verwendung von zwei Ätzmasken, die übereinander angeordnet sind. Hierbei wird im ersten Ätzschritt eine zurückweichende Maske mit vergleichsweise starkem Ätzabtrag verwendet, um die geneigten Seitenflächen 7, 8 zu erzeugen. In einem zweiten Ätzschritt wird dabei eine Hartmaske verwendet, mit der senkrechte Seitenabschnitte erzeugt werden. In diesem Schritt wird die Ausnehmung 6 auf die gewünschte Tiefe geätzt, wobei die geneigt angeordneten Seitenflächen 7, 8 in einem kritischen unteren Bereich erhalten bleiben. Beispielsweise kann der Übergang vom ersten zum zweiten Schritt auch erfolgen, wenn die erste Maske mit einem hohen Ätzabtrag aufgebraucht, das heißt vollständig abgetragen wird. Zudem können Ätzmasken mit unterschiedlicher Härte und damit unterschiedlicher Abtragerate auf gegenüber liegenden Seiten der Ausnehmung angeordnet sein. Dadurch können auf den verschiedenen Seiten unterschiedliche Neigungswinkel der Seitenflächen auf einfache Weise durch unterschiedlich stark lateral abzutragende Ätzmasken erreicht werden. Eine weiche Ätzmaske kann z.B. aus Photolack bestehen, der für fotolithografische Verfahren eingesetzt wird. Zudem kann die weiche Maske auch aus SiNx oder einem Halbleitermaterial oder einem Metall bestehen.

Zudem können die Ausnehmungen 6, 25 auch durch die Verwendung von zwei Ätzprozessschritten hergestellt werden, wobei der erste Ätzprozessschritt eine hohe Abtragerate aufweist und damit geneigt angeordnet Seitenflächen 7, 8 erzeugt. Im zweiten Prozessschritt wird zum Ätzen der Ausnehmungen 6, 25 bis auf die gewünschte Tiefe ein Ätzplasma und entsprechende Plasmaparameter verwendet, die eine geringere Abtragerate aufweisen und senkrechte Flanken erzeugen. Dabei wird in kritischen Tiefenbereichen der Ausnehmungen 6, 25 aufgrund der geringeren Abtragerate eine geringere Schädigung der angrenzenden Schichtstruktur 2 bewirkt. Trotzdem können die geneigt angeordneten Seitenflächen 7, 8 erhalten bleiben. Zudem ist auch der umgekehrte Fall möglich, wobei die geneigt angeordneten Seitenflächen 7, 8 sich im oberen Teil der Ausnehmungen 6, 25 befinden. Dies kann beispielsweise prozessbedingt durch die unterschiedlichen Ätzraten und unterschiedliche Epitaxieschichten erreicht werden.

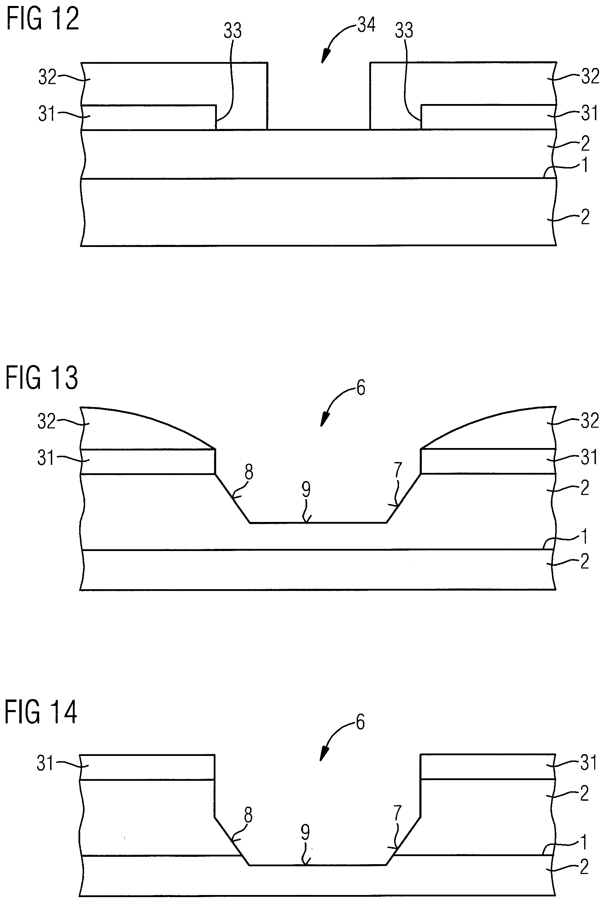

Die Fig. 12 bis 14 zeigen Schritte eines ersten Verfahrens zum Einbringen der Ausnehmung 6 in eine Schichtstruktur 2. Fig. 12 zeigt in einer schematischen Darstellung eine Schichtstruktur 2 mit Epitaxieschichten, die eine aktive Zone 1 zum Erzeugen einer elektromagnetischen Strahlung aufweist. Die Schichtstruktur 2 kann auf einem Träger aufgebracht sein, der nicht dargestellt ist. Auf der Schichtstruktur 2 ist eine erste Ätzmaske 31 aufgebracht. Auf der ersten Ätzmaske ist eine zweite Ätzmaske 32 aufgebracht. Die zweite Ätzmaske 32 überdeckt einen Randbereich 33 der ersten Ätzmaske und definiert dadurch eine Ätzöffnung 34. In dem dargestellten Beispiel weist die zweite Ätzmaske 32 eine geringere Härte als die erste Ätzmaske 31 auf und/oder es wird in einem ersten Ätzschritt ein Ätzverfahren verwendet, das eine laterale Abtragung der zweiten Ätzmaske 32 bewirkt. Die geringere Härte der zweiten Ätzmaske bewirkt während des Ätzprozesses einen lateralen Abtrag der zweiten Ätzmaske.

Dadurch wird, wie in Fig. 13 dargestellt, eine Ausnehmung 6 erhalten, die geneigte Seitenflächen 7,8 aufweist. In einem zweiten Ätzschritt wird nun die Tiefe der Ausnehmung 6 vergrößert, wobei die Struktur der Bodenfläche mit den geneigten Seitenflächen 7,8 beibehalten bleibt. Dazu ist die erste Ätzmaske 31 aus einem härteren Material ausgebildet, so dass im Wesentlichen kein lateraler Abtrag der ersten Ätzmaske 31 während des zweiten Ätzschrittes erfolgt. Zudem kann während des zweiten Ätzschrittes ein Ätzverfahren verwendet werden, das eine geringe bzw. keinen lateralen Abtrag der ersten Ätzmaske 31 bewirkt. Mithilfe des zweiten Ätzschrittes wird die Bodenfläche 9 der Ausnehmung 6 bis in die gewünschte Tiefe im Bereich der Ebene der aktiven Zone 1 gebracht, wie in Fig. 14 dargestellt ist. Dabei werden aufgrund der Stabilität der ersten Ätzmaske 31 im oberen Bereich der Ausnehmung 6 Seitenflächen ausgebildet, die im Wesentlichen senkrecht zur Ebene der aktiven Zone 1 angeordnet sind.

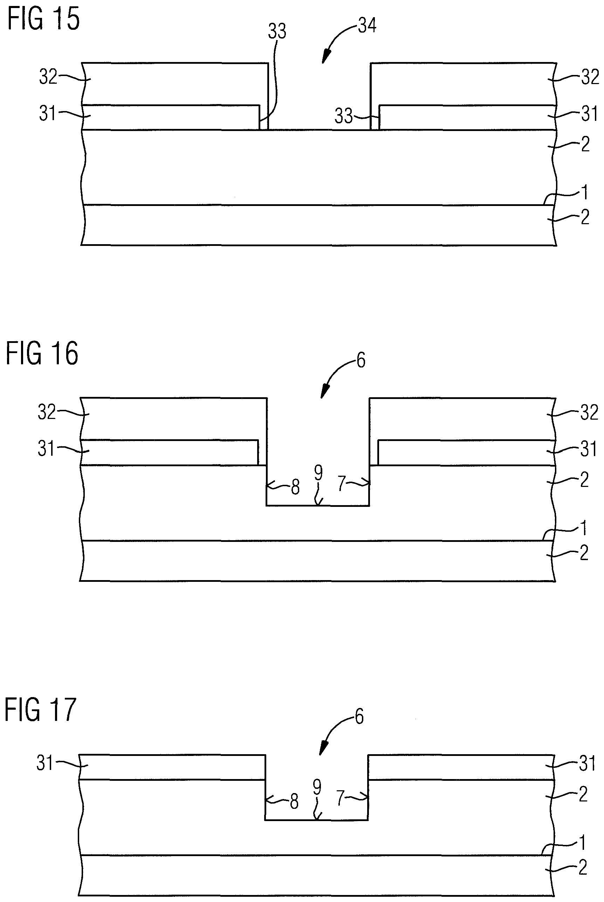

Die Fig. 15 bis 18 zeigen Verfahrensschritte eines zweiten Verfahrens zum Einbringen einer Ausnehmung 6 in eine Schichtstruktur 2. Fig. 15 zeigt in einer schematischen Darstellung eine Schichtstruktur 2 mit Epitaxieschichten und mit einer aktiven Zone 1 zum Erzeugen einer elektromagnetischen Strahlung aufweist. Die Schichtstruktur 2 kann auf einem Träger aufgebracht sein, der nicht dargestellt ist. Auf der Schichtstruktur 2 ist eine erste Ätzmaske 31 aufgebracht. Auf der ersten Ätzmaske 31 ist eine zweite Ätzmaske 32 aufgebracht. Die zweite Ätzmaske 32 überdeckt einen Randbereich 33 der ersten Ätzmaske nur geringfügig oder gar nicht. Somit wird die Ätzöffnung 34 durch die zweite Ätzmaske 32, wie dargestellt, oder durch die erste Ätzmaske 31 definiert. In dem dargestellten Beispiel weist die zweite Ätzmaske 32 eine größere Härte als die erste Ätzmaske 31 auf und/oder es wird in einem ersten Ätzschritt ein Ätzverfahren verwendet, das im Wesentlichen keinen lateralen Abtrag der zweiten Ätzmaske 32 bewirkt.

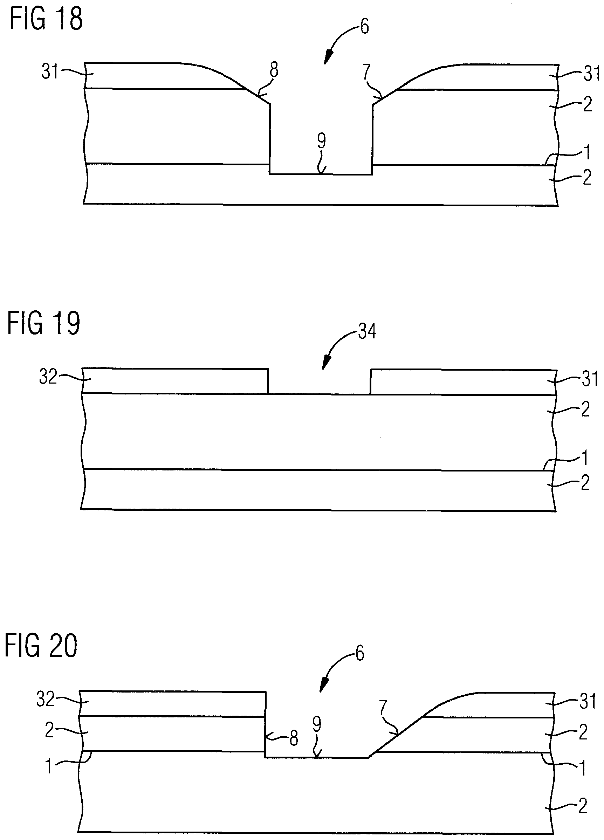

Dadurch wird, wie in Fig. 16 dargestellt, eine Ausnehmung 6 erhalten, die Seitenflächen aufweist, die im Wesentlichen senkrecht zur Ebene der aktiven Zone 1 angeordnet sind. Anschließend wir die zweite Ätzmaske 32 entfernt, wie in Fig. 17 dargestellt ist. In einem folgenden zweiten Ätzschritt wird nun die Tiefe der Ausnehmung 6 vergrößert, wobei die untere Struktur der Ausnehmung 6 mit der Bodenfläche und mit den senkrechten Seitenflächen im unteren Bereich der Ausnehmung beibehalten wird. Jedoch werden im oberen Bereich der Ausnehmung 6 geneigt angeordnete Seitenflächen 7,8 ausgebilddet. Dazu kann die erste Ätzmaske 31 aus einem weicheren Material ausgebildet sein, so dass ein lateraler Abtrag der ersten Ätzmaske 31 während des zweiten Ätzschrittes erfolgt. Zudem kann während des zweiten Ätzschrittes ein Ätzverfahren verwendet werden, das einen lateralen Abtrag auch einer härteren ersten Ätzmaske 31 bewirkt. Mithilfe des zweiten Ätzschrittes wird die Tiefe der Bodenfläche 9 der Ausnehmung 6 bis in die gewünschte Tiefe im Bereich der Ebene der aktiven Zone 1 gebracht, wie in Fig. 18 dargestellt.

Fig. 19 und 20 zeigen Verfahrensschritte eines dritten Verfahrens, mit dem eine Ausnehmung 6 mit unterschiedlich geneigten Seitenflächen 7,8 in eine Schichtstruktur 2 eingebracht werden kann, die Epitaxieschichten und eine aktive Zone 1 zum Erzeugen elektromagnetischer Strahlung aufweist. Dazu sind auf der Schichtstruktur 2 eine erste und eine zweite Ätzmaske 31,32 angeordnet, die eine Ätzöffnung 34 von zwei Seiten begrenzen. In dem dargestellten Beispiel weist die zweite Ätzmaske 32 eine geringere Härte als die erste Ätzmaske 31 auf, so dass bei der zweiten Ätzmaske 32 während eines Ätzprozesses ein lateraler Abtrag erfolgt, der größer ist als der laterale Abtrag der ersten Ätzmaske 31. Auf diese Weise wird eine Ausnehmung 6 erhalten, die eine Bodenfläche 9 und zwei unterschiedlich geneigte Seitenflächen 7,8 aufweist. Die Bodenfläche 9 ist im gewünschten Bereich in der Nähe der Ebene der aktiven Zone 1 angeordnet. Die Neigungen der Seitenflächen 7,8 können durch unterschiedliche Härten bzw. laterale Widerstandsfestigkeit der Ätzmasken gegenüber dem Ätzverfahren eingestellt werden. In dem dargestellten Beispiel weist die erste Seitenfläche 7 einen Winkel von 95° bis 160° gegenüber der Ebene der aktiven Zone 1 auf. Die zweite Seitenfläche 8 ist senkrecht zur Ebene der aktiven Zone 1 angeordnet. Entsprechend wurde die zweite Ätzmaske 32 lateral nicht bzw. kaum abgetragen. Abhängig von der gewählten Ausführung können die erste und/oder die zweite Seitenfläche 7,8 auch andere Neigungswinkel aufweisen, insbesondere kann der Neigungswinkel der zweiten Seitenfläche 8 auch im Bereich zwischen 95° und 160° gegenüber der Ebene der aktiven Zone 1 liegen.

Die Erfindung wird durch die Ansprüche definiert.

### Bezugszeichenliste

- 1: aktive Zone
- 2: Schichtstruktur
- 3: Steg
- 4: Lasermodenbereich
- 5: Oberfläche
- 6: Ausnehmung
- 7: erste Seitenfläche
- 8: zweite Seitenfläche
- 9: Bodenfläche
- 10: seitlicher Randbereich
- 11: Graben
- 12: Bruchrichtung
- 13: Endfläche
- 14: Versetzung
- 15: Substrat
- 16: Schichten
- 17: erster Übergangsbereich
- 18: zweiter Übergangsbereich
- 19: erster Seitenabschnitt
- 20: zweiter Seitenabschnitt
- 21: weiterer erster Seitenabschnitt
- 22: weiterer zweiter Seitenabschnitt
- 23: weitere erste Bodenfläche
- 24: weitere zweite Bodenfläche
- 25: zweite Ausnehmung
- 26: dritte Seitenfläche
- 27: vierte Seitenfläche
- 28: Winkel
- 29: zweite Endfläche
- 31: erste Ätzmaske
- 32: zweite Ätzmaske
- 33: Randbereich
- 34: Ätzöffnung

## Patentansprüche

1. Optoelektronisches Bauelement mit einer Schichtstruktur (2) mit einer aktiven Zone (1) zum Erzeugen einer elektromagnetischen Strahlung, wobei die aktive Zone (1) in einer ersten Ebene angeordnet ist, wobei in die Oberfläche der Schichtstruktur (2) eine Ausnehmung (6, 25) eingebracht ist, wobei die Ausnehmung (6, 25) an eine Endfläche (13) des Bauelementes angrenzt, wobei die Endfläche (13) in einer zweiten Ebene angeordnet ist, wobei die zweite Ebene im Wesentlichen senkrecht zur ersten Ebene angeordnet ist, wobei die Ausnehmung (6, 25) eine Bodenfläche (9) und eine Seitenfläche (7, 8) aufweist, wobei die Seitenfläche (7, 8) im Wesentlichen senkrecht zur Endfläche (13) angeordnet ist, wobei die Seitenfläche (7, 8) in einem Winkel geneigt ungleich 90° zu der ersten Ebene der aktiven Zone angeordnet ist, wobei die Bodenfläche (9) im Bereich der ersten Ebene der aktiven Zone (1) angeordnet ist, wobei der Bereich von 200 nm über der Ebene der aktiven Zone (1) bis zu 200 nm oder weiter unter der Ebene der aktiven Zone (1) reicht, **dadurch gekennzeichnet dass** die wenigstens eine Seitenfläche (7, 8) der Ausnehmung (6, 25) eine abgestufte Form mit wenigstens zwei Seitenabschnitten (19, 20, 21, 22) aufweist, wobei die Seitenabschnitte (19, 20, 21, 22) seitlich versetzt angeordnet sind, wobei die Seitenabschnitte (19, 20, 21, 22) über eine zweite Bodenfläche (23, 24) miteinander verbunden sind, und wobei wenigstens ein Seitenabschnitt (19, 20, 21, 22) als geneigte Seitenfläche ausgebildet ist.

2. Bauelement nach Anspruch 1, wobei die Bodenfläche (9) in einer Tiefe zwischen 100 nm und 800 nm unter einer Oberfläche (5) der Schichtstruktur (2) angeordnet ist.

3. Bauelement nach einem der vorhergehenden Ansprüche, wobei die geneigt angeordnete Seitenfläche (7, 8, 19, 20, 21, 22) in einem Winkel von 95°-160° insbesondere zwischen 98° und 130° geneigt angeordnet ist.

4. Bauelement nach einem der vorhergehenden Ansprüche, wobei die Ausnehmung eine zweite Seitenfläche (8) aufweist, und wobei die zweite Seitenfläche (8) gegenüberliegend zur ersten Seitenfläche (7) angeordnet ist, und wobei insbesondere die erste und die zweite Seitenfläche (7,8) in unterschiedlichen Winkeln angeordnet sind.

5. Bauelement nach einem der vorhergehenden Ansprüche, wobei die Seitenfläche (7, 8) einen im Wesentlichen senkrecht gegenüber der ersten Ebene angeordneten Flächenabschnitt und einen geneigten Flächenabschnitt aufweist, wobei der geneigte Flächenabschnitt der Seitenfläche in einem oberen Flächenabschnitt (19, 20) der Seitenfläche (7, 8) bezogen auf eine Tiefe der Seitenfläche angeordnet ist, und wobei der im Wesentlichen senkrecht angeordnete Flächenabschnitt in einem unteren Bereich (21, 22) der Seitenfläche (7, 8) angeordnet ist.

6. Bauelement nach einem der vorhergehenden Ansprüche, wobei die Seitenfläche (7, 8) einen im Wesentlichen senkrecht gegenüber der ersten Ebene angeordneten Flächenabschnitt und einen geneigten Flächenabschnitt aufweist, wobei der geneigte Flächenabschnitt der Seitenfläche in einem unteren Flächenabschnitt (21, 22) der Seitenfläche (7, 8) bezogen auf eine Tiefe der Seitenfläche angeordnet ist, und wobei der im Wesentlichen senkrecht angeordnete Flächenabschnitt in einem oberen Bereich (19, 20) der Seitenfläche (7, 8) angeordnet ist.

7. Bauelement nach einem der Ansprüche 1 bis 5, wobei die Ausnehmung (6, 25) in einer Ebene parallel zur zweiten Ebene wenigstens einen gerundeten Übergang (17, 18) zwischen der Seitenfläche (7, 8) der Ausnehmung (6, 25) und einer Oberseite (5) der Schichtstruktur (2) und/oder einer Bodenfläche (9, 23) der Ausnehmung aufweist.

8. Bauelement nach einem der vorhergehenden Ansprüche, wobei die Ausnehmung (6, 25) eine Breite in der zweiten Ebene aufweist, die im Bereich von 10 µm bis 200 µm liegt.

9. Bauelement nach einem der vorhergehenden Ansprüche, wobei die Ausnehmung (6, 25) einen Abstand von einem Steg (3) aufweist, der im Bereich von 10 µm bis 150 µm liegt.

10. Bauelement nach einem der vorhergehenden Ansprüche, wobei ein Mesagraben (11) vorgesehen ist, wobei der Mesagraben (11) in der zweiten Ebene seitlich versetzt zur Ausnehmung (6, 25) zwischen einer Seite (10) des Bauelementes und der Ausnehmung (6, 25) angeordnet ist.

11. Verfahren zur Herstellung eines Bauelementes nach einem der vorhergehenden Ansprüche, wobei die Ausnehmung mithilfe eines Ätzprozesses in die Schichtstruktur eingebracht wird, wobei während des Ätzprozesses eine laterale Aufweitung einer Ätzöffnung (34) einer Ätzmaske (31) wenigstens teilweise erfolgt, so dass eine Ausnehmung (6) in eine Schichtstruktur (2) eingebracht wird, die wenigstens eine geneigt angeordnete Seitenfläche (7,8) aufweist.

12. Verfahren nach Anspruch 11, wobei unterschiedlich harte Ätzmasken (31,32) verwendet werden, um eine Ausnehmung (6) mit wenigstens einer geneigten Seitenfläche (7,8) zu erzeugen, und wobei insbesondere die weichere Ätzmaske eine Maske aus Photolack oder SiNx oder einem Halbleitermaterial oder aus Metall gebildet ist, die insbesondere wenigstens teilweise lateral abgetragen wird.

## Claims

1. Optoelectronic component comprising a layer structure (2) comprising an active zone (1) for generating an electromagnetic radiation, wherein the active zone (1) is arranged in a first plane, wherein a recess (6, 25) is introduced into the surface of the layer structure (2), wherein the recess (6, 25) adjoins an end face (13) of the component, wherein the end face (13) is arranged in a second plane, wherein the second plane is arranged substantially perpendicularly to the first plane, wherein the recess (6, 25) comprises a bottom face (9) and a side face (7, 8), wherein the side face (7, 8) is arranged substantially perpendicularly to the end face (13), wherein the side face (7, 8) is arranged in a manner inclined at an angle not equal to 90° with respect to the first plane of the active zone, wherein the bottom face (9) is arranged in the region of the first plane of the active zone (1), wherein the region extends from 200 nm above the plane of the active zone (1) to 200 nm or more below the plane of the active zone (1), **characterized in that** the at least one side face (7, 8) of the recess (6, 25) comprises a stepped shape comprising at least two side sections (19, 20, 21, 22), wherein the side sections (19, 20, 21, 22) are arranged in a laterally offset fashion, wherein the side sections (19, 20, 21, 22) are connected to one another via a second bottom face (23, 24), and wherein at least one side section (19, 20, 21, 22) is formed as an inclined side face.

2. Component according to claim 1, wherein the bottom face (9) is arranged at a depth of between 100 nm and 800 nm below a surface (5) of the layer structure (2).

3. Component according to any one of the preceding claims, wherein the side face (7, 8, 19, 20, 21, 22) arranged in an inclined manner is arranged in a manner inclined at an angle of 95°-160°, in particular between 98° and 130°.

4. Component according to any one of the preceding claims, wherein the recess comprises a second side face (8), and wherein the second side face (8) is arranged opposite with respect to the first side face (7), and in particular wherein the first and second side faces (7, 8) are arranged at different angles.

5. Component according to any one of the preceding claims, wherein the side face (7, 8) comprises a face section arranged substantially perpendicularly relative to the first plane, and an inclined face section, wherein the inclined face section of the side face is arranged in an upper face section (19, 20) of the side face (7, 8) in relation to a depth of the side face, and wherein the face section arranged substantially perpendicularly is arranged in a lower region (21, 22) of the side face (7, 8).

6. Component according to any one of the preceding claims, wherein the side face (7, 8) comprises a face section arranged substantially perpendicularly relative to the first plane, and an inclined face section, wherein the inclined face section of the side face is arranged in a lower face section (21, 22) of the side face (7, 8) in relation to a depth of the side face, and wherein the face section arranged substantially perpendicularly is arranged in an upper region (19, 20) of the side face (7, 8) .

7. Component according to any one of Claims 1 to 5, wherein the recess (6, 25) comprises in a plane parallel to the second plane at least one rounded transition (17, 18) between the side face (7, 8) of the recess (6, 25) and a top side (5) of the layer structure (2) and/or a bottom face (9, 23) of the recess.

8. Component according to any one of the preceding claims, wherein the recess (6, 25) comprises a width in the second plane that is in the range of 10 µm to 200 µm.

9. Component according to any one of the preceding claims, wherein the recess (6, 25) comprises a distance from a ridge (3) that is in the range of 10 µm to 150 µm.

10. Component according to any one of the preceding claims, wherein a mesa trench (11) is provided, wherein the mesa trench (11) is arranged in the second plane in a laterally offset fashion with respect to the recess (6, 25) between a side (10) of the component and the recess (6, 25).

11. Method for producing a component according to any one of the preceding claims, wherein the recess is introduced into the layer structure with the aid of an etching process, wherein a lateral widening of an etching opening (34) of an etching mask (31) is at least partly carried out during the etching process, such that a recess (6) is introduced into a layer structure (2), which comprises at least one side face (7, 8) arranged in an inclined manner.

12. Method according to Claim 11, wherein etching masks (31, 32) of different hardnesses are used in order to produce a recess (6) comprising at least one inclined side face (7, 8) and wherein in particular the softer etching mask is a mask composed of photoresist or SiNx or a semiconductor material or is formed from metal, which mask is removed in particular at least partly laterally.

## Revendications

1. Composant optoélectronique doté d'une structure stratifiée (2) pourvue d'une zone active (1) destinée à générer un rayonnement électromagnétique, la zone active (1) étant placée dans un premier plan, dans la surface de la structure stratifiée (2) étant ménagé un évidement (6, 25), l'évidement (6, 25) étant adjacent à une surface d'extrémité (13) du composant, la surface d'extrémité (13) étant placée dans un deuxième plan, le deuxième plan étant placé sensiblement à la perpendiculaire du premier plan, l'évidement (6, 25) comportant une surface de fond (9) et une surface latérale (7, 8), la surface latérale (7, 8) étant placée sensiblement à la perpendiculaire de la surface d'extrémité (13), la surface latérale (7, 8) étant placée sous un angle incliné non égal à 90° par rapport au premier plan de la zone active, la surface de fond (9) étant placée dans la région du premier plan de la zone active (1), la région s'étendant de 200 nm au-dessus du plan de la zone active (1) jusqu'à 200 nm ou plus en-dessous du plan de la zone active (1), **caractérisé en ce que** l'au moins une surface latérale (7, 8) de l'évidement (6, 25) présente une forme échelonnée avec au moins deux sections latérales (19, 20, 21, 22), les sections latérales (19, 20, 21, 22) étant placées avec un décalage latéral, les sections latérales (19, 20, 21, 22) étant assemblées l'une à l'autre par l'intermédiaire d'une seconde surface de fond (23, 24), et au moins une section latérale (19, 20, 21, 22) étant conçue sous la forme d'une surface latérale inclinée.

2. Composant selon revendication 1, la surface de fond (9) étant placée à une profondeur comprise entre 100 nm et 800 nm en-dessous d'une surface (5) de la structure stratifiée (2).

3. Composant selon l'une quelconque des revendications précédentes, la surface latérale (7, 8, 19, 20, 21, 22) placée en inclinaison étant placée en étant inclinée sous un angle de 95° à 160°, notamment compris entre 98° et 130°.

4. Composant selon l'une quelconque des revendications précédentes, l'évidement comportant une deuxième surface latérale (8) et la deuxième surface latérale (8) étant placée au regard de la première surface latérale (7) et notamment les première et deuxième surfaces latérales (7, 8) étant placées sous des angles différents.

5. Composant selon l'une quelconque des revendications précédentes, la surface latérale (7, 8) comportant une portion de surface placée sensiblement à la perpendiculaire par rapport au premier plan et une portion de surface inclinée, la portion de surface inclinée de la surface latérale étant placée dans une portion de surface (19, 20) supérieure de la surface latérale (7, 8), en rapport à une profondeur de la surface latérale et la portion de surface placée sensiblement à la perpendiculaire étant placée dans une région inférieure (21, 22) de la surface latérale (7, 8).

6. Composant selon l'une quelconque des revendications précédentes, la surface latérale (7, 8) comportant une portion de surface placée sensiblement à la perpendiculaire par rapport au premier plan et une portion de surface inclinée, la portion de surface inclinée de la surface latérale étant placée dans une portion de surface (21, 22) inférieure de la surface latérale (7, 8), en rapport à une profondeur de la surface latérale, et
la portion de surface placée sensiblement à la perpendiculaire étant placée dans une région (19, 20) supérieure de la surface latérale (7, 8).

7. Composant selon l'une quelconque des revendications 1 à 5, l'évidement (6, 25) comportant dans un plan parallèle au deuxième plan au moins un passage (17, 18) arrondi entre la surface latérale (7, 8) de l'évidement (6, 25) et une face supérieure (5) de la structure stratifiée (2) et/ou une surface de fond (9, 23) de l'évidement.

8. Composant selon l'une quelconque des revendications précédentes, l'évidement (6, 25) présentant dans le deuxième plan une largeur qui se situe dans l'ordre de 10 µm à 200 µm.

9. Composant selon l'une quelconque des revendications précédentes, l'évidement (6, 25) présentant un écart par rapport à un listel (3) qui se situe dans l'ordre de 10 µm à 150 µm.

10. Composant selon l'une quelconque des revendications précédentes, une tranchée mésa (11) étant prévue, la tranchée mésa (11) étant placée dans le deuxième plan, avec un décalage latéral par rapport à l'évidement (6, 25), entre un côté (10) du composant et l'évidement (6, 25).

11. Procédé, destiné à fabriquer un composant selon l'une quelconque des revendications précédentes, l'évidement étant ménagé dans la structure stratifiée à l'aide d'un processus de gravure, pendant le processus de gravure se produisant au moins partiellement un évasement latéral d'un orifice de gravure (34) d'un masque d'attaque (31), de telle sorte qu'un évidement (6) qui comporte au moins une surface latérale (7, 8) placée en inclinaison soit ménagé dans une structure stratifiée (2).

12. Procédé selon la revendication 11, des masques d'attaque (31, 32) de différentes duretés étant utilisés pour créer un évidement (6) pourvu d'au moins une surface latérale (7, 8) et dans lequel notamment le masque d'attaque le plus souple étant un masque en photo-réserve ou en SiNx ou en une matière semi-conductrice ou en métal, qui est enlevé au moins en partie latéralement.
